# EUROPEAN PATENT SPECIFICATION

(11) **EP 4 446 457 B1**
(45) Date of publication and mention of the grant of the patent: **17.06.2026**
(21) Application number: 24167710.3
(22) Date of filing: 28.03.2024
(51) Int. Cl.: C23C 14/04, C23C 14/50, H10P 72/72, H10P 72/76

(54) **ELECTROSTATIC CHUCK, DEPOSITION APPARATUS INCLUDING THE SAME, AND DISPLAY PANEL FABRICATED USING THE SAME**
ELEKTROSTATISCHE EINSPANNVORRICHTUNG, ABSCHEIDUNGSVORRICHTUNG DAMIT UND DAMIT HERGESTELLTE ANZEIGETAFEL
MANDRIN ÉLECTROSTATIQUE, APPAREIL DE DÉPÔT LE COMPRENANT ET PANNEAU D'AFFICHAGE FABRIQUÉ À L'AIDE DE CELUI-CI

(30) Priority: 11.04.2023 KR 20230047423
(43) Date of publication of application: 16.10.2024
(73) Proprietor: Samsung Display Co., Ltd., Yongin-si, Gyeonggi-do 17113 (KR)
(72) Inventor: YOU, Suk Beom, 17113 Yongin-si (KR); LEE, Sung Yong, 17113 Yongin-si (KR); KIM, Dong Hyun, 17113 Yongin-si (KR); KIM, Myung Kyu, 17113 Yongin-si (KR)
(74) Representative: Taor, Simon Edward William

(56) References cited:
- US-A1- 2022 359 171
- US-B2- 11 282 733
- US-B2- 9 713 818

## Description

### CROSS-REFERENCE TO RELATED APPLICATION(S)

This application claims priority to and benefits of Korean Patent Application No. 10-2023-0047423 filed on April 11, 2023, in the Korean Intellectual Property Office.

### BACKGROUND

### 1. Technical Field

The disclosure relates to an electrostatic chuck, a deposition apparatus including the same, and a display panel fabricated using the same.

### 2. Description of the Related Art

Display devices become more and more important as multimedia technology evolves. Accordingly, a variety of display devices such as liquid-crystal display devices (LCDs) and organic light-emitting diode display devices (OLEDs) are currently being developed.

Such a display device may include a display panel to provide visual information such as images or video to a user. To form such a display panel, layers of the display panel may be formed by a variety of methods. In doing so, a method for forming the layers may include a deposition process, a photomask process, etc.

In a deposition method, to perform a deposition process by vaporizing a deposition material and spraying it, a deposition source is disposed below, a mask is placed above the deposition source, and a substrate is disposed on the mask so that the deposition material passing through the mask is deposited on the substrate. In doing so, the distance between the mask and the substrate may determine the precision of a deposition material pattern deposited on the substrate. By way of example, the deposition material pattern is a very important issue for the resolution and performance of a display unit, and can determine the quality of the product.

For example, if the mask and the substrate are not in tight contact with each other during the deposition process, the deposition material may be deposited on an undesired zone on the substrate, for example, a dead zone, resulting in display defects. This phenomenon is called a shadow effect. In order to fabricate a high-resolution display device, it is necessary to reduce or eliminate such a shadow effect. Therefore, in order to reduce or eliminate the shadow phenomenon, it is required to improve adhesion between the substrate and the mask.

In order to reduce display defects, it is necessary to dispose the substrate flat. A substrate deflects in a direction toward a deposition source due to its own weight. If a deposition process is carried out on the deflected substrate, the substrate and the mask are not properly adhered to each other, and accordingly it is highly likely that the deposition material is deposited on the dead zone of the substrate. As a result, the display defect rate also increases.

In order to dispose the substrate flat, an electrostatic chuck and a tension device for tensioning the electrostatic chuck may be disposed. The electrostatic chuck is a member that attaches a substrate using electrostatic force. The tension device tensions the electrostatic chuck to thereby tension the substrate attached to the electrostatic chuck.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein. US9713818B2 discloses a deposition apparatus and a deposition method. US2022/0359171 discloses a substrate processing equipment for high pressure plasma processing. US11282733B2 discloses a stage mechanism including an electrostatic chuck.

### SUMMARY

Aspects of the disclosure provide an electrostatic chuck and a deposition apparatus that suppresses the deflection of the electrostatic chuck.

Aspects of the disclosure also provide a deposition apparatus that fabricates a display panel with suppressed shadow phenomenon by improving the accuracy of the deposition process.

It should be noted that objects of the disclosure are not limited to the above-mentioned objects, and other objects will be apparent to those skilled in the art from the following descriptions.

According to an aspect of the disclosure, there is provided an electrostatic check as set out in claim 1. Additional features are set out in claims 2 to 9. According to an aspect of the disclosure, there is provided a deposition apparatus as set out in claim 10. Additional features are set out in claims 11 to 13..

According to an embodiment of the disclosure, it is possible to suppress the deflection of an electrostatic chuck.

According to an embodiment, it is possible to fabricate a display panel with suppressed shadow phenomenon by improving the accuracy of a deposition process.

It should be noted that effects of the disclosure are not limited to those described above and other effects of the disclosure will be apparent to those skilled in the art from the following descriptions.

### BRIEF DESCRIPTION OF THE DRAWINGS

The above and other aspects and features of the disclosure will become more apparent by describing in detail embodiments thereof with reference to the attached drawings, in which:
FIG. 1 is a schematic cross-sectional view showing a deposition apparatus according to an embodiment.
FIG. 2 is a schematic perspective view showing an electrostatic chuck according to an embodiment.
FIG. 3 is a schematic plan view showing the electrostatic chuck according to an embodiment.
FIG. 4 is a schematic cross-sectional view taken along line X1 - X1' in FIG. 3.
FIG. 5 is a schematic cross-sectional view showing a tension assist device according to an embodiment.
FIG. 6 is a schematic cross-sectional view showing an existing electrostatic chuck in case that it is tensioned.
FIG. 7 is a schematic cross-sectional view showing the electrostatic chuck according to an embodiment in case that it is tensioned.
FIG. 8 is a view illustrating the degree of deflection according to the tensed length of the electrostatic chuck according to an embodiment.
FIG. 9 is a schematic cross-sectional view showing an electrostatic chuck according to an embodiment.
FIG. 10 is a schematic cross-sectional view showing an electrostatic chuck according an embodiment.
FIG. 11 is a schematic cross-sectional view showing an electrostatic chuck according an embodiment.
FIG. 12 is a schematic perspective view showing an electrostatic chuck according to an embodiment.
FIG. 13 is a schematic plan view showing an electrostatic chuck according to an embodiment.
FIG. 14 is a schematic cross-sectional view showing an electrostatic chuck according an embodiment.
FIG. 15 is a schematic cross-sectional view showing an electrostatic chuck according to an embodiment in case that it is tensioned.
FIG. 16 is a view illustrating the degree of deflection according to the tensioned length of the electrostatic chuck according to an embodiment.
FIG. 17 is a schematic plan view showing an electrostatic chuck according to an embodiment.
FIG. 18 is a flowchart for illustrating a method of fabricating a display panel according to an embodiment.
FIG. 19 is a schematic cross-sectional view showing step S100 of FIG. 18.
FIG. 20 is a schematic cross-sectional view showing step S200 of FIG. 18.
FIG. 21 is a schematic cross-sectional view showing step S300 of FIG. 18.
FIG. 22 is a schematic cross-sectional view showing step S400 of FIG. 18.
FIG. 23 is a schematic cross-sectional view showing step S500 of FIG. 18.
FIG. 24 is a schematic cross-sectional view showing step S600 of FIG. 18.
FIG. 25 is a schematic cross-sectional view illustrating an example of a display panel fabricated using the deposition apparatus and the method for fabricating a display panel according to the above-described embodiments.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

The embodiments related to the invention are detailed in the appended claims.

It will also be understood that when a layer is referred to as being "on" another layer or substrate, it can be directly on the other layer or substrate, or intervening layers may also be present. The same reference numbers indicate the same components throughout the specification.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described in detail with reference to the accompanying drawings.

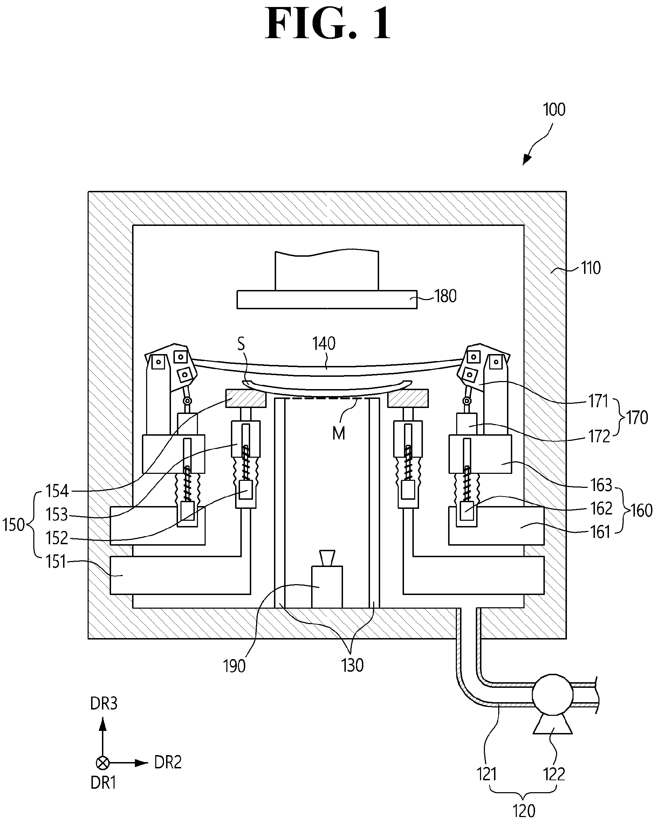

FIG. 1 is a schematic cross-sectional view showing a deposition apparatus according to an embodiment.

Referring to FIG. 1, a deposition apparatus 100 may include a chamber 110, a pressure adjusting unit (or part) 120, a mask holder 130, an electrostatic chuck 140, a first lifting unit (or part) 150, a second lifting unit (or part) 160, a tension unit (or part) 170, a magnet unit (or part) 180, and a deposition source 190.

The chamber 110 may define an internal space of the deposition apparatus 100. A space may be formed inside the chamber 110, and the pressure inside it may be variable. The pressure adjusting unit 120 may be connected to the chamber 110 to adjust the pressure inside the chamber 110.

The pressure adjusting unit 120 may include a pipe 121 connected to the chamber 110 and a pump 122 installed in the pipe 121. Gas inside the chamber 110 is discharged to the outside through the pipe 121 according to the operation of the pump 122, so that the pressure inside the chamber 110 can be adjusted.

The mask holder 130 may be installed inside the chamber 110 to support a mask M. Although the mask holder 130 is installed inside the chamber 110 and simply supports the mask M in the example shown in FIG. 1, embodiments of the disclosure are not limited thereto. The mask holder 130 may be installed such that it is linearly movable with respect to the chamber 110. According to an embodiment, the mask M may be, but is not limited to, a fine metal mask.

In case that the mask holder 130 is installed so that it can move linearly with respect to the chamber 110, the mask holder 130 may be connected to a separate lifting device (not shown). For example, the mask holder 130 may include any device or structure that is connected to the mask holder 130 and can provide a driving force to the mask holder 130, such as a motor and a cylinder.

The substrate S may be provided from the outside of the chamber 110 to the inside of the chamber 110 by a robot arm (not shown). The substrate S provided into the chamber 110 may be disposed between the mask M and the electrostatic chuck 140 in the third direction DR3. The substrate S may be disposed on a support 154 of the first lifting unit 150. After the substrate S is attached to the electrostatic chuck 140, it is aligned with the mask M by an aligning device (not shown). The alignment between the mask M and the substrate S may be carried out whenever necessary throughout the deposition process.

According to an embodiment disclosure, the substrate S may be a mother substrate for fabricating display panels. The substrate S may have a large area and may have lengths of about 2.2 m and about 2.5 m in the first and second directions DR1 and DR2, respectively. It should be understood, however, that embodiments of the disclosure are not limited thereto. The substrate S may have a variety of sizes. The substrate S may deflect in the direction opposite to the third direction DR3, for example, in the downward direction due to its own weight.

In the drawings, the first direction DR1 and the second direction DR2 intersect each other as the horizontal directions. For example, the first direction DR1 and the second direction DR2 may be perpendicular to each other. A third direction DR3 may intersect the first direction DR1 and the second direction DR2, and may be a vertical direction, for example. Herein, the side indicated by the arrow of each of the first to third directions DR1, DR2 and DR3 may be referred to as a first side, while the opposite side may be referred to as a second side. It should be noted that in case that only each direction is referred without specific reference to the first side and the second side in the direction, it may imply that the direction may include at least one of the first side and the second side.

The electrostatic chuck 140 may be placed above the substrate S. The electrostatic chuck 140 may be disposed above the first lifting unit 150. The size of the electrostatic chuck 140 may be larger than that of the substrate S. Accordingly, like the substrate S, the electrostatic chuck 140 may also deflect toward the substrate S, for example, in the downward direction due to its own weight.

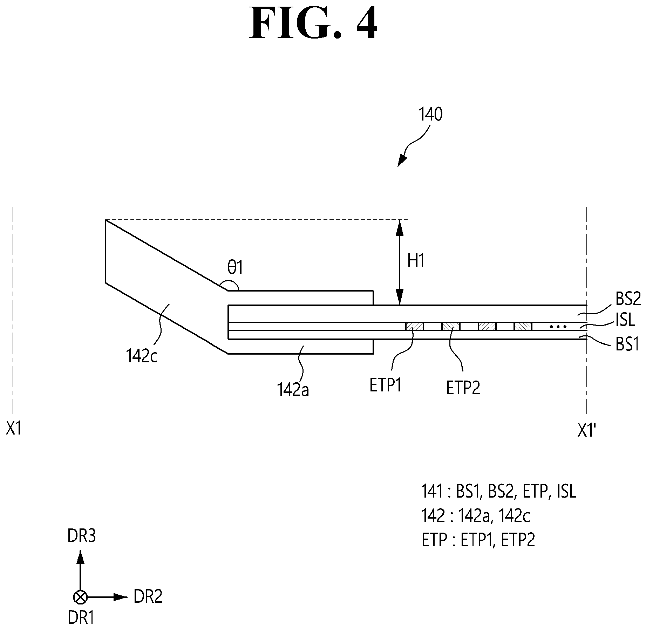

The electrostatic chuck 140 may attach the substrate S to the electrostatic chuck 140. The electrostatic chuck 140 may attach the substrate S to the electrostatic chuck 140 with electrostatic force by applying a voltage to an electrode pattern ETP (see FIG. 4).

The first lifting unit 150 may be disposed below the electrostatic chuck 140. The first lifting unit 150 may be disposed on each of the both sides of the mask holder 130. For example, the first lifting unit 150 may be disposed on one side or a side and the opposite side of the mask holder 130 in the second direction DR2. Although not shown in the drawings, the first lifting unit 150 may be disposed on each of one side or a side and the opposite side of the mask holder 130 in the first direction DR1 as well.

The first lifting unit 150 may include a first support 151, a first driver 152, a first connector 153 and a support plate 154.

The first support 151 may support the first driver 152, the first connector 153, and the support plate 154. Although the first support 151 is connected to a sidewall of the chamber 110 in the drawing, embodiments of the disclosure are not limited thereto. It may be connected to the bottom of the chamber 110 or connected to another member to work as a support.

The first driver 152 may be disposed on the first support 151. The first driver 152 may provide a driving force for elevating the first connector 153 and the support plate 154. The first driver 152 may include any device or structure that moves an object, such as a cylinder and a motor.

The first connector 153 may connect the first driver 152 with the support plate 154. The first connector 153 may be disposed between the first driver 152 with the support plate 154. For example, the first connector 153 may be disposed between the first driver 152 and the support plate 154 in the third direction DR3.

The support plate 154 may be disposed on the first connector 153. The support plate 154 may provide a support surface on which the substrate S is seated. For example, as shown in the drawing, the support 154 may include a support plate respectively disposed on both sides of the mask holder 130 with the mask holder 130 therebetween. It should be noted that the support 154 may include any shape as long as it provides a support surface on which the substrate S can be seated and the deposition material passing through the mask M can be deposited on the substrate S.

Although not shown in the drawings, the support 154 may be disposed to surround the mask holder 130 in the first and second directions DR1 and DR2.

The second lifting unit 160 may be disposed under or below the tension unit 170. The second lifting unit 160 may be disposed on one side or a side of the first lifting unit 150. For example, the second lifting unit 160 may be disposed on each of one side or a side and the opposite side of the first lifting unit 150 in the second direction DR2. Although not shown in the drawings, the second lifting unit 160 may be disposed on each of one side or a side and the opposite side of the first lifting unit 150 in the first direction DR1 as well.

The second lifting unit 160 may include a second support 161, a second driver 162, and a second connector 163.

The second support 161 may support the second driver 162, the second connector 163, and the tension unit 170. Although the second support 161 is connected to a sidewall of the chamber 110 in the drawing, embodiments of the disclosure are not limited thereto. It may be connected to the bottom of the chamber 110 or connected to another member to work as a support.

The second driver 162 may be disposed on the second support 161. The second driver 162 may provide a driving force for elevating the second connector 163 and the tension unit 170. The second driver 162 may include any device or structure that moves an object, such as a cylinder and a motor.

The second connector 163 may connect the second lifting unit 160 with the tension unit 170. For example, the second connector 163 may connect the second driver 162 with the tension unit 170. The second connector 163 may be disposed between the second driver 162 and the tension unit 170. For example, the second connector 163 may be disposed between the second driver 162 and the tension unit 170 in the third direction DR3.

The tension unit 170 may be disposed on the second lifting unit 160. The tension unit 170 may be disposed on each of the both sides of the electrostatic chuck 140. For example, the tension unit 170 may be disposed on each of the first side and the second side of the electrostatic chuck 140 in the second direction DR2. Although not shown in the drawing, the tension unit 170 may be disposed on each of the first side and the second side of the electrostatic chuck 140 in the first direction DR1 as well. For example, the tension unit 170 may be disposed on each of the both first side and second side of the electrostatic chuck 140 in the first direction DR1 and the second direction DR2 to apply tensile force to the electrostatic chuck 140 in up, down, left and right directions when viewed from the top.

The tension unit 170 may include a presser 171 and a third driver 172.

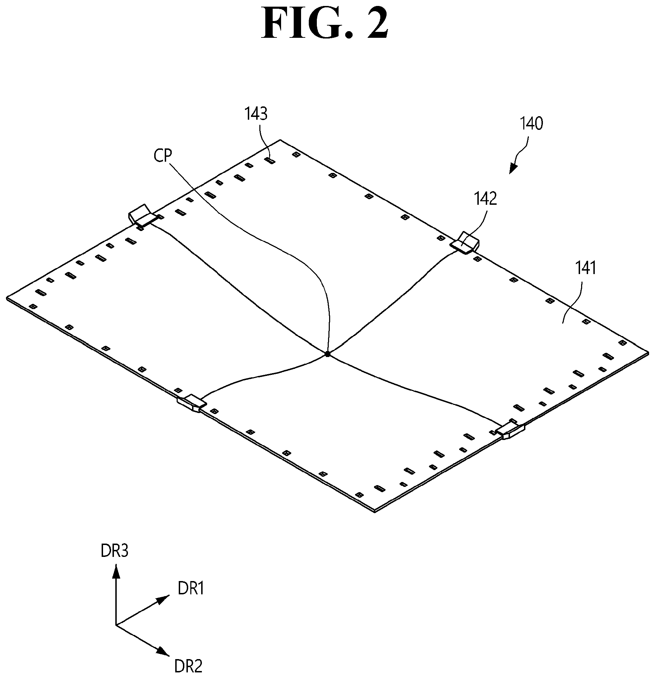

The presser 171 may provide tensile force to the electrostatic chuck 140. The presser 171 may be coupled (or connected) to a tension assist device 142 (see FIG. 2) of the electrostatic chuck 140 to provide tensile force to the electrostatic chuck 140. For example, the presser 171 may be coupled to each of the both sides of the electrostatic chuck 140 in the first and second directions DR1 and DR2, to provide a tensile force acting on the first side and the second side of the electrostatic chuck 140 to the electrostatic chuck 140 in the first direction DR1 and the second direction DR2. The electrostatic chuck 140 that deflects downward can become flat by virtue of the tensile force provided by the presser 171, and the substrate S attached to the electrostatic chuck 140 can also become flat together.

According to an embodiment, the presser 171 may apply a tensile force to the electrostatic chuck 140 while rotating in a clockwise or counterclockwise direction. It should be understood, however, that embodiments of the disclosure are not limited thereto. Any driving scheme may be included as long as a tensile force can be applied in the horizontal direction.

The third driver 172 may provide driving force to the presser 171. For example, the third driver 172 may include a crank to rotate the presser 171 by converting linear motion into rotational motion. It should be understood, however, that embodiments of the disclosure are not limited thereto. A driving force may be provided to the presser 171 in a variety of driving manners.

The magnet unit 180 may be disposed above the electrostatic chuck 140. The magnet unit 180 may be disposed on the side opposite to the surface of the electrostatic chuck 140 to which the substrate S is attached. For example, the magnet unit 180 may be disposed above the electrostatic chuck 140 in the third direction DR3.

The magnet unit 180 may further include a separate lifting device (not shown) capable of lifting the magnet unit 180. In case that the electrostatic chuck 140 to which the substrate S is attached moves and comes in contact with the mask M, the magnet unit 180 may move towards the electrostatic chuck 140 by driving the lifting device (not shown). The magnet unit in contact with the electrostatic chuck 140 may apply magnetic force to bring the mask M disposed on the opposite side into tight contact with the substrate S, with the electrostatic chuck 140 therebetween. Furthermore, the magnet unit 180 may apply pressure to the electrostatic chuck 140, the substrate S and the mask M, which are attached together, to further bring them into tight contact.

The deposition source 190 may spray a deposition material. The deposition material sprayed from the deposition source 190 may pass through the mask M and settle on the substrate S.

In the deposition apparatus 100 according to this embodiment, the electrostatic chuck 140 may include the tension assist device 142 (see FIG. 2), so that it is possible to suppress deflection of the electrostatic chuck 140 and the substrate S, thereby improving the accuracy of the deposition process. This will be described with reference to FIG. 2 and the like within the scope of the disclosure.

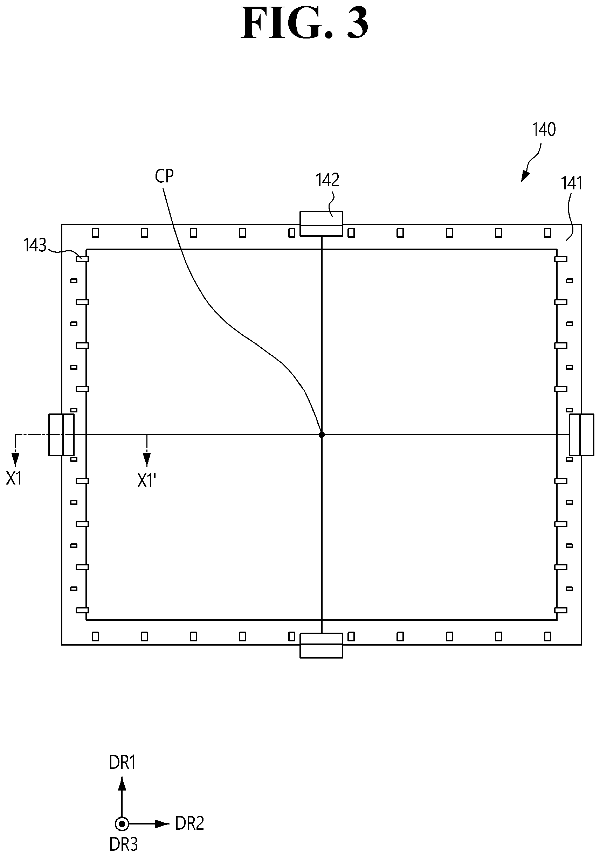

FIG. 2 is a schematic perspective view showing an electrostatic chuck according to an embodiment. FIG. 3 is a schematic plan view showing the electrostatic chuck according to an embodiment.

Referring to FIGS. 2 and 3 in conjunction with FIG. 1, the electrostatic chuck 140 may have a thin plate shape. The electrostatic chuck 140 may be made of a thin film. According to an embodiment, the thickness of the electrostatic chuck 140 may be, but is not limited to, about 10 mm.

As shown in the drawings, since the electrostatic chuck 140 is thin but has a large size, it may deflect in the direction opposite to the third direction DR3, for example, in the downward direction due to its own weight. By way of example, the point corresponding to the center of gravity CP of the electrostatic chuck 140 may deflect the most. For example, in case that the electrostatic chuck 140 is symmetrical in the first direction DR1 and the second direction DR2, the center of gravity CP of the electrostatic chuck 140 may be the exact center of the electrostatic chuck 140, and the exact center of the electrostatic chuck 140, which is the center of gravity (CP), may deflect the most.

The electrostatic chuck 140 may include a body 141, tension assist devices 142, and alignment marks 143.

The body 141 may conform to the shape of the substrate S. For example, the body 141 may have a rectangular shape. The body 141 may include two shorter sides extended in the first direction DR1 and facing each other in the second direction DR2, and two longer sides extended in the second direction DR2 and facing each other in the first direction DR1. It is to be understood that the shape of the body 141 is not limited thereto but may have various shapes such as a square, a circle, and a polygon. The size of the body 141 may be larger than that of the substrate S.

The tension assist devices 142 may be coupled to the body 141. The tension assist devices 142 may be coupled to the border of the body 141, for example, the edges of the body 141. According to an embodiment, the tension assist devices 142 may be disposed at the centers of the sides of the body 141, respectively. Although not shown in the drawings, according to an embodiment, the tension assist devices 142 may be disposed on vertices where the sides of the body 141 meet each other. For example, in order to increase the transmission of the tensile force, the tension assist devices 142 may be disposed at points closest to the center of gravity CP of the body 141 (for example, the center of each side) on the respective sides.

In some embodiments, tension assist devices 142 may be disposed on each of the sides of the body 141. Although one tension assist device 142 is disposed on each of the sides of the body 141 in the drawings, embodiments of the disclosure are not limited thereto. In case that tension assist devices 142 are disposed on each side, a transmission of tension force can be increased.

The alignment marks 143 may be disposed on the edges of the body 141. Alignment marks 143 may be formed. The alignment marks 143 may have different shapes, but embodiments of the disclosure are not limited thereto. The electrostatic chuck 140 may be aligned with the substrate S to be attached by an alignment device (not shown) recognizing the alignment marks 143.

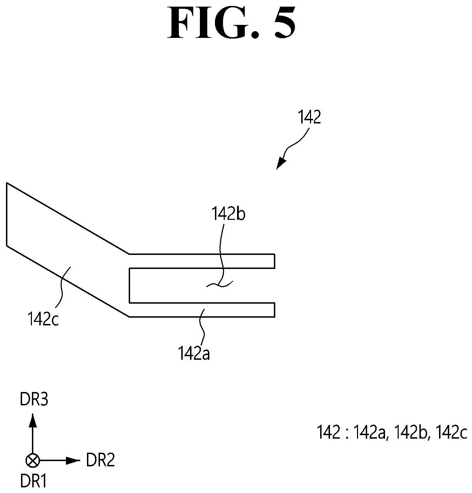

FIG. 4 is a schematic cross-sectional view taken along line X1 - X1' in FIG. 3. FIG. 5 is a schematic cross-sectional view showing a tension assist device according to an embodiment.

Referring to FIGS. 4 and 5, the body 141 may include a first base BS1, an electrode pattern ETP, an insulating film ISL, and a second base BS2.

The first base BS1 and the second base BS2 may face each other in the third direction DR3. Each of the first base BS1 and the second base BS2 may work as an insulating dielectric and may be a base substrate made of a ceramic material. The first base BS1 and the second base BS2 can prevent electric current flowing through the electrode pattern ETP from directly flowing to the substrate S.

The insulating film ISL may include a ceramic material or an insulating organic material. For example, the insulating film ISL may include aluminum nitride, aluminum oxide, magnesium oxide, polyimide, etc. The insulating film ISL can prevent electric current flowing through the electrode pattern ETP from directly flowing to the substrate S.

In some embodiments, the first base BS1, the second base BS2 and the insulating film ISL may include the same material or a similar material. For example, the first base BS1, the second base BS2 and the insulating film ISL may be a single insulating structure surrounding the electrode pattern ETP.

The electrode pattern ETP may be disposed between the first base BS1 and the second base BS2. The electrode pattern ETP may be surrounded by the insulating film ISL. The electrode pattern ETP may have a plus or minus potential by a voltage supplied from a separate power supply unit (not shown). Electrode patterns ETP may be formed.

The electrode pattern ETP may include a first electrode pattern ETP1 having a plus potential and a second electrode pattern ETP2 having a minus potential. According to an embodiment, the first electrode pattern ETP1 and the second electrode pattern ETP2 may be arranged alternately in the first and second directions DR1 and DR2.

Electrostatic force may be generated by the alternately arranged first electrode patterns ETP1 and second electrode patterns ETP2, and the substrate S may be attached to the electrostatic chuck 140 by the electrostatic force.

A tension assist device 142 may include a coupling portion 142a, a recessed portion 142b, and a stepped portion 142c.

The coupling portion 142a may fix the tension assist device 142 to the body 141. The coupling portion 142a may overlap the edge of the body 141 in the third direction DR3 in case that the tension assist device 142 is coupled to the body 141.

The coupling portion 142a may be in direct contact with the first base BS1 and the second base BS2 of the body 141. For example, the coupling portion 142a may include an upper end and a lower end. The body 141 may be disposed between the upper end and the lower end of the coupling portion 142a in the third direction DR3. The upper and lower ends of the coupling part 142a may be engaged with the body 141 to fix the tension assist device 142 to the body 141.

The coupling portion 142a may have a shape protruding from the stepped portion 142c to one side or a side in the first direction DR1 or the second direction DR2. For example, the coupling portion 142a may protrude toward the body 141 in the first direction DR1 or the second direction DR2 with the recessed portion 142b therebetween in the third direction DR3. The coupling portion 142a may overlap the recessed portion 142b in the third direction DR3.

The body 141 may be inserted into the recessed portion 142b. The recessed portion 142b may provide a space into which the body 141 can be inserted. The recessed portion 142b may overlap the edge of the body 141 in the third direction DR3 in case that the tension assist device 142 is coupled to the body 141. The recessed portion 142b may accommodate the body 141 so that the body 141 can be inserted into the tension assist device 142.

The recessed portion 142b may be recessed from one end or an end of the coupling portion 142a in the first direction DR1 or the second direction DR2. The recessed portion 142b may overlap the coupling portion 142a. For example, the recessed portion 142b may be disposed between the upper end and the lower end of the coupling portion 142a in the third direction DR3.

The stepped portion 142c may be disposed on one side or a side of the body 141. The stepped portion 142c may have a shape protruding to one side or a side from the coupling portion 142a and the recessed portion 142b. For example, the stepped portion 142c may have a shape protruding in a diagonal direction between the opposite direction to the first direction DR1 and the third direction DR3, or in a diagonal direction between the opposite direction to the second direction DR2 and the third direction DR3.

One end or an end of the stepped portion 142c, for example, the end distant from the body 141, may be disposed higher than the upper surface of the body 141. For example, the end of the stepped portion 142c may be positioned higher than the upper surface of the body 141 by a first height H1. The first height H1 may range from about several millimeters to about several tens of millimeters. The end of the stepped portion 142c may be disposed higher than the upper surface of the coupling portion 142a.

As shown in FIG. 4, a first angle θ1, which is an angle between the extension direction of the stepped portion 142c and the extension direction of the coupling portion 142a, may be less than 180 degrees. For example, the first angle θ1 may be an obtuse angle according to this embodiment.

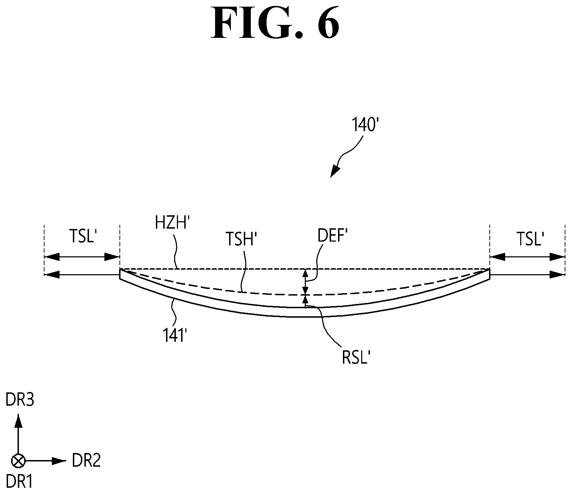

In the deposition apparatus 100 according to this embodiment, the tension assist device 142 of the electrostatic chuck 140 may include the stepped portion 142c, so that it is possible to suppress deflection of the electrostatic chuck 140 and the substrate S, thereby improving the accuracy of the deposition process. In this regard, an existing electrostatic chuck will be described with reference to FIG. 6 and the like for comparison.

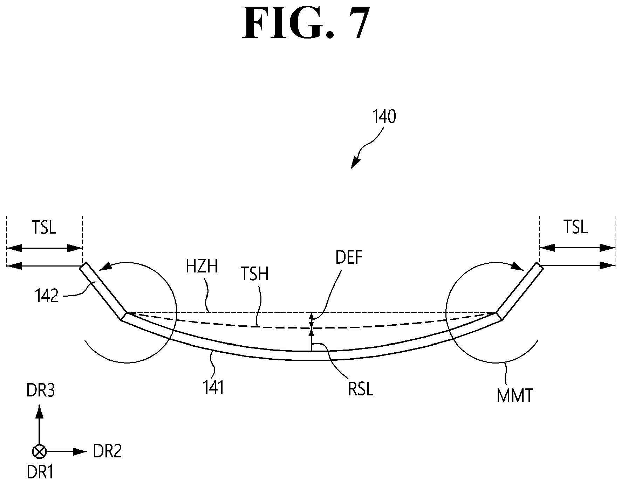

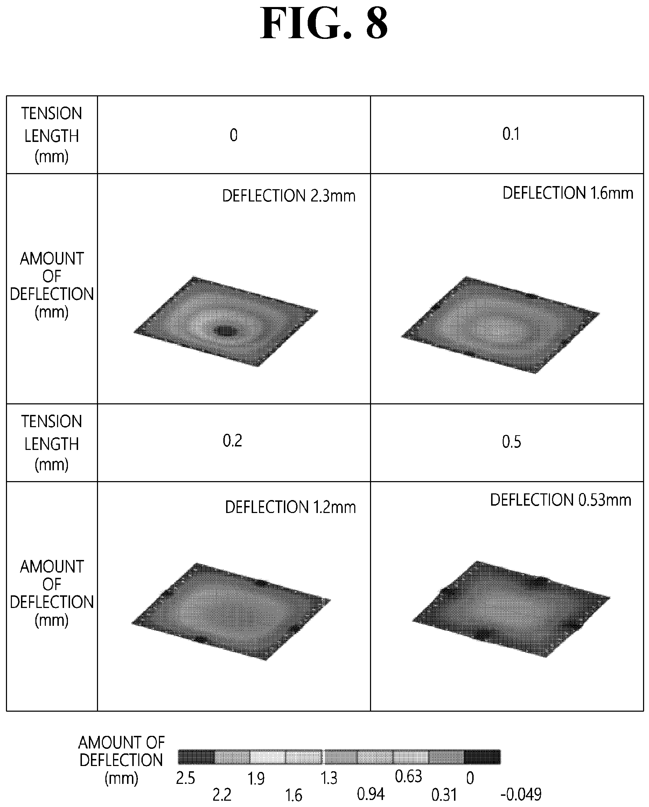

FIG. 6 is a schematic cross-sectional view showing an existing electrostatic chuck in case that it is tensioned. FIG. 7 is a schematic cross-sectional view showing the electrostatic chuck according to an embodiment in case that it is tensioned. FIG. 8 is a view illustrating the degree of deflection according to the tension length of the electrostatic chuck according to an embodiment.

Referring to FIGS. 6 to 8 in conjunction with FIG. 1, an existing electrostatic chuck 140' may not include the tension assist devices 142. The electrostatic chuck 140 according to this embodiment may include the tension assist devices 142. Both the existing electrostatic chuck 140' and the electrostatic chuck 140 according to this embodiment may deflect downward due to their own weights.

Since the existing electrostatic chuck 140' may include no tension assist device 142, a tension unit of a deposition apparatus may be directly coupled to the body 141' to apply tensile force. The tensile unit 170 may directly apply a tensile force to the body 141' by pulling one side or a side and the opposite side of the body 141' by a tension length TSL' in the first direction DR1 and the second direction DR2. In case that the tensile force is applied by the tension unit 170 in the first and second directions DR1 and DR2, the body 141' may be moved in the third direction DR3 by a rising length RSL' to reach a tension height line TSH'.

Table 1 below shows the amount of deflection DEF' according to the tension length TSL' of the existing electrostatic chuck 140'. The amount of deflection DEF' may refer to the maximum distance between the tension height line TSH' and the horizontal height line HZH' with respect to the both ends of and the body 141' in case that the electrostatic chuck 140' is tensioned by the tension length TSL'.

**[Table 1]**

| | | | | |
|---|---|---|---|---|
| Tension Length (mm) | 0 | 0.1 | 0.2 | 0.5 |
| Amount of Deflection (mm) | 2.3 | 1.8 | 1.6 | 1.2 |

In contrast, the electrostatic chuck 140 according to this embodiment may include the tension assist device 142, the tension unit 170 of the deposition apparatus may be coupled to the tension assist device 142 instead of the body 141 to apply tensile force. The tensile unit 170 may indirectly apply a tensile force to the body 141 by pulling the tension assist device 142 disposed on one side or a side and the opposite side of the body 141 by a tension length TSL in the first direction DR1 and the second direction DR2. In case that the tensile force is applied by the tension unit 170 to the tension assist device 142 in the first and second directions DR1 and DR2, the tension assist device 142 may transmit it to the body 141. The body 141 may be moved in the third direction DR3 by a rising length RSL to reach a tension height line TSH.

Table 2 below shows the amount of deflection DEF according to the tension length TSL of the electrostatic chuck 140 according to this embodiment. The amount of deflection DEF may refer to the maximum distance between the tension height line TSH and the horizontal height line HZH with respect to the both ends of and the body 140 in case that the electrostatic chuck 141 is tensioned by the tension length TSL.

**[Table 2]**

| | | | | |
|---|---|---|---|---|
| Tension Length (mm) | 0 | 0.1 | 0.2 | 0.5 |
| Amount of Deflection (mm) | 2.3 | 1.6 | 1.2 | 0.53 |

It can be seen from the data of Table 1 and Table 2 that the electrostatic chuck 140 according to this embodiment exhibits improved amount of deflection DEF according to the tension length TSL compared to the amount of deflection DEF' according to the tension length TSL' of the existing electrostatic chuck 140'. It can be seen that as the tension lengths TSL and TSL' increase, the difference between the amount of deflection DEF of the electrostatic chuck 140 and the amount of deflection DEF of the existing electrostatic chuck 140' increases. In other words, it can be seen that the degree of improvement in the amounts of deflection DEF and DEF' increases as the tension lengths TSL and TSL' increase.

The amount of deflection of the electrostatic chuck 140 can be improved compared to the existing electrostatic chuck 140' because of rotational moment MMT. In the electrostatic chuck 140 according to this embodiment, as the tension assist device 142 having a height difference is pulled to the both sides, the rotational moment MMT acting in a clockwise or counterclockwise direction can be generated. As a result, the lifting force acting in the third direction DR3, for example, the upward direction, is further increased, and thus the rising length RSL can be increased.

As such, the electrostatic chuck 140 according to this embodiment may include the tension assist device 142 having a height difference, so that the deflection of the electrostatic chuck 140 can be reduced. Accordingly, the accuracy of the deposition process can be improved.

Hereinafter, electrostatic chucks according to other embodiments will be described. In the following description, the same or similar elements will be denoted by the same or similar reference numerals, and redundant descriptions will be omitted or briefly described.

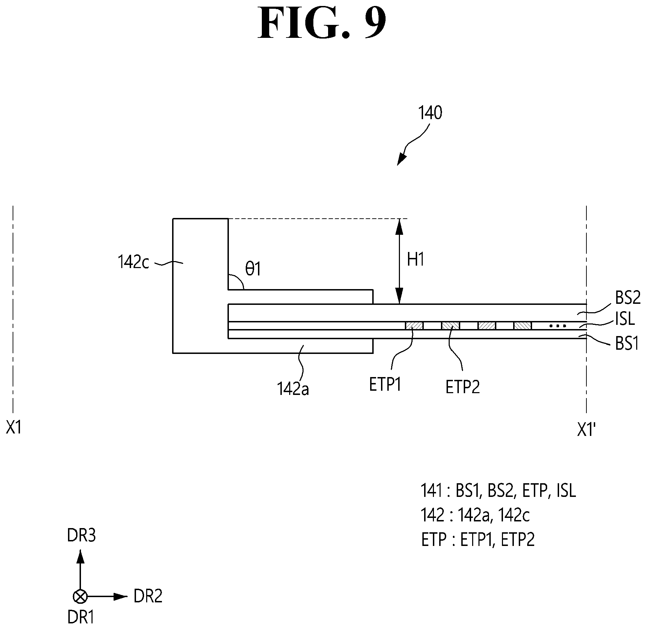

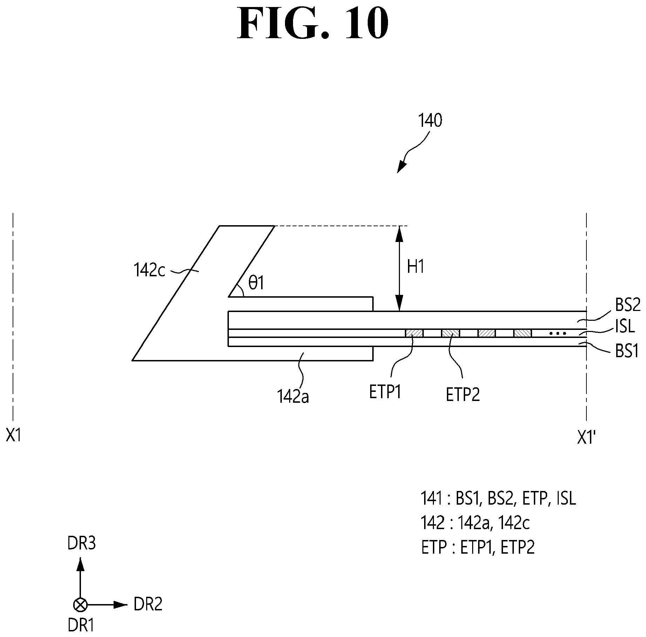

FIG. 9 is a schematic cross-sectional view showing an electrostatic chuck according to an embodiment. FIG. 10 is a schematic cross-sectional view showing an electrostatic chuck according to an embodiment.

Referring to FIGS. 9 and 10 in conjunction with FIG. 7, electrostatic chucks 140 according to these embodiments may be different from the electrostatic chuck according to an embodiment described above with reference to FIG. 4 and the like in that a first angle θ1 may be smaller.

For example, a first angle θ1 of an electrostatic chuck 140 according to the embodiment shown in FIG. 9 may be a right angle. A first angle θ1 of the electrostatic chuck 140 according to the embodiment shown in FIG. 10 may be an acute angle.

The first angle θ1 of the electrostatic chucks 140 according to these embodiments as well as the first angle θ1 of the electrostatic chuck according to the embodiment described above with reference to FIG. 4 are smaller than 180 degrees, and the former is even smaller.

As such, as the first angle θ1 decreases, the force of the rotational moment MMT may increase for the same tension length TSL. The rising length RSL according to the tension length TSL can be adjusted appropriately by adjusting the magnitude of the first angle θ1.

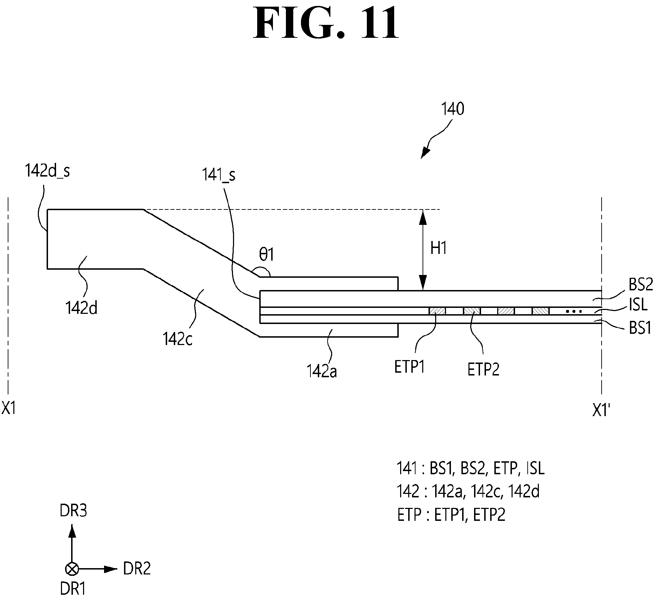

FIG. 11 is a schematic cross-sectional view showing an electrostatic chuck according to an embodiment.

Referring to FIG. 11 in conjunction with FIG. 1, an electrostatic chuck 140 according to an embodiment may be different from the electrostatic chuck according to an embodiment described above with reference to FIG. 4 and the like in that the former may further include an auxiliary end 142d.

For example, the electrostatic chuck 140 according to this embodiment may further include an auxiliary end 142d.

The auxiliary end 142d may be disposed on one side or a side of the stepped portion 142c. For example, the auxiliary end 142d may be disposed at one end or an end of the stepped portion 142c, for example, at the end distant from the body 141. The auxiliary end 142d may be disposed on the opposite side of the coupling portion 142a with the stepped part 142c therebetween.

According to an embodiment, the auxiliary end 142d may be extended in a direction parallel to the extension direction of the coupling portion 142a. For example, the auxiliary end 142d may be parallel to the first direction DR1 or the second direction DR2, for example, the horizontal direction. The extension direction of a side surface 142d_s of the auxiliary end 142d may be parallel to the extension direction of a side surface 141_s of one end or an end of the body 141. For example, the extension direction of the side surface 142d_s of the auxiliary end 142d may be parallel to the third direction DR3, for example, the vertical direction.

The auxiliary end 142d may work as a connecting portion coupled to the tension unit 170. For example, the auxiliary end 142d may be coupled to a presser 171 of the tension unit 170. In case that the extension direction of the auxiliary end 142d is parallel to the horizontal direction, the extension direction of the auxiliary end 142d may be identical to the tensile direction of the tension unit 170. For example, the tension unit 170 may apply a tensile force in the same direction as the extending direction of the auxiliary end 142d.

Although the auxiliary end 142d is further included in the electrostatic chuck 140 according to the embodiment described above with reference to FIG. 4 and the like in the drawing, embodiments of the disclosure are not limited thereto. For example, the auxiliary end 142d may be further included in the electrostatic chucks 140 according to embodiments described above with reference to FIGS. 9 and 10.

According to an embodiment, the extension direction of the auxiliary end 142d may be in a direction different from the horizontal direction. Although the auxiliary end 142d is extended in the opposite direction to the second direction DR2 in the drawing, embodiments of the disclosure are not limited thereto. For example, the auxiliary end 142d may be extended to the first side and the second side in the first and second directions DR1 and DR2, as well as in a diagonal direction between the first direction DR1 and the third direction DR3, and in a diagonal direction between the second direction DR2 and the third direction DR2. As another example, the auxiliary end 142d may be extended in the vertical direction, for example, the first side and the second side in the third direction DR3.

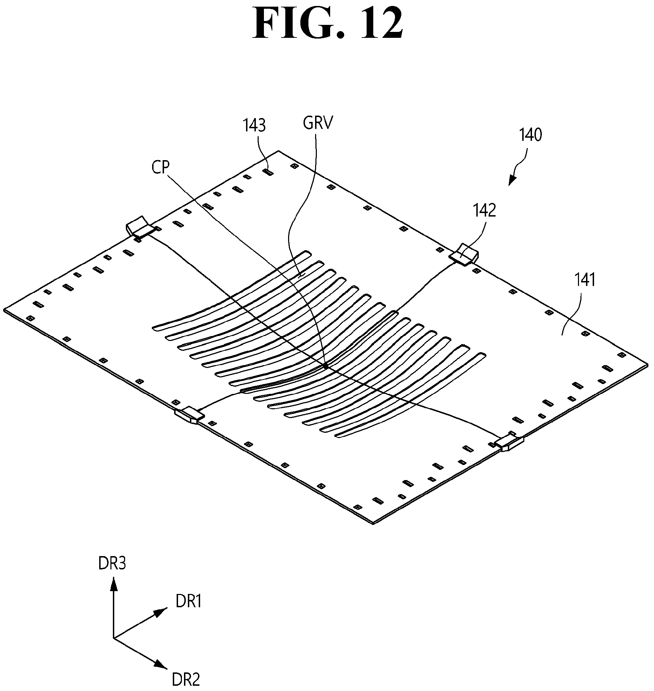

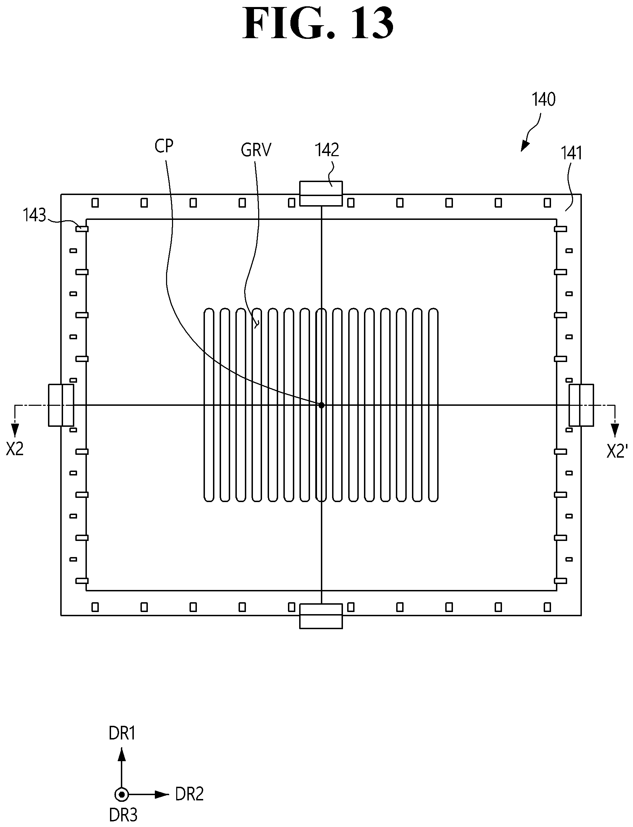

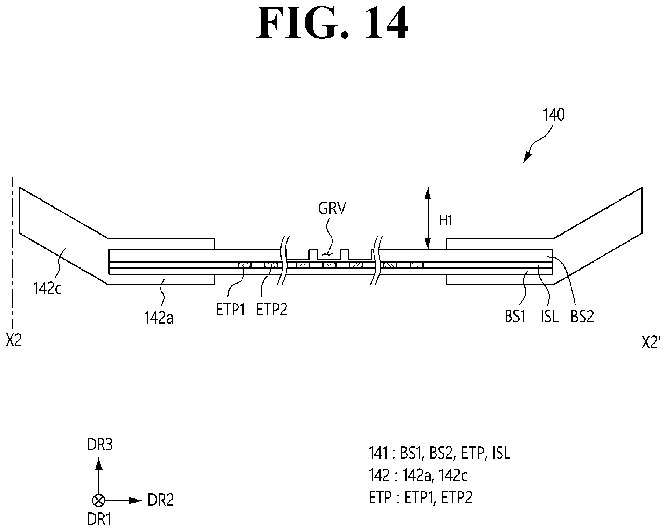

FIG. 12 is a schematic perspective view showing an electrostatic chuck according to an embodiment. FIG. 13 is a schematic plan view showing an electrostatic chuck according to an embodiment. FIG. 14 is a schematic cross-sectional view showing an electrostatic chuck according to an embodiment.

Referring to FIGS. 12 to 14 in conjunction with FIG. 1, an electrostatic chuck 140 according to an embodiment may be different from the electrostatic chuck according to an embodiment described above with reference to FIG. 2 and the like in that the former may further include at least one groove GRV.

For example, the electrostatic chuck 140 according to this embodiment may further include the groove GRV.

The groove GRV may be disposed adjacent to the central portion of the body 141 where the center of gravity CP of the body 141 is disposed, but embodiments of the disclosure are not limited thereto. Grooves GRV may be formed. The grooves may be extended in the first direction DR1 and be spaced apart from one another in the second direction DR2.

The grooves GRV may be formed in the second base BS2. The grooves GRV may be formed on the electrode pattern ETP. In order to avoid disconnection of the electrode pattern ETP and keep insulation from the outside, the grooves GRV may not be formed in the layer where the electrode pattern ETP and the insulating film ISL are disposed.

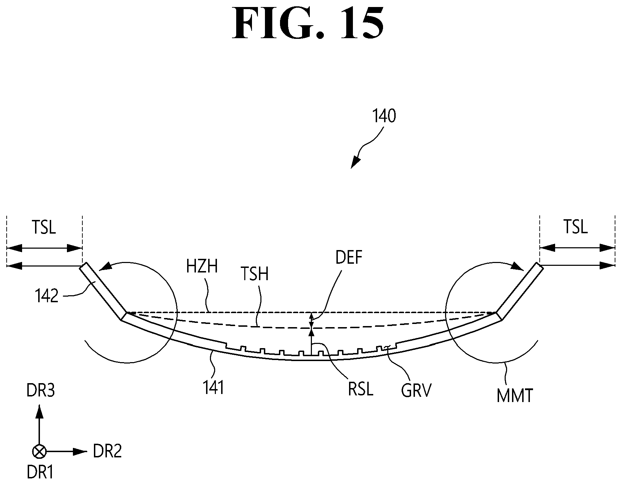

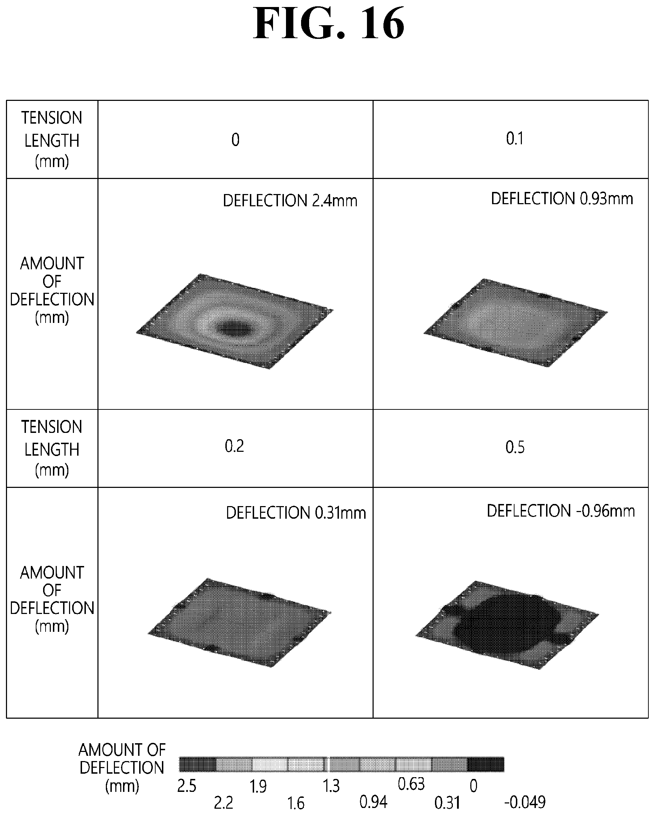

FIG. 15 is a schematic cross-sectional view showing an electrostatic chuck according to an embodiment in case that it is tensioned. FIG. 16 is a view illustrating the degree of deflection according to the tension length of the electrostatic chuck according to an embodiment.

Referring to FIGS. 15 and 16 in conjunction with FIGS. 1, 7 and 8, the electrostatic chuck 140 according to this embodiment further may include grooves GRV to reduce the weight of the electrostatic chuck 140. As the weight is reduced by including the grooves GRV, it is possible to more effectively prevent the deflection by the tension assist device 142.

For example, in case that the tension unit 170 pulls the tension assist device 142 by a tension length TSL, the body 141 may move in the third direction DR3 by a rising length RSL to reach a tension height line TSH. The rising length RSL of the electrostatic chuck 140 according to this embodiment may be greater than the rising length RSL of the electrostatic chuck 140 according to the above-described embodiment for the same tension length TSL.

Table 3 below shows the amount of deflection DEF according to the tension length TSL of the electrostatic chuck 140 according to this embodiment. The amount of deflection DEF may refer to the maximum distance between the tension height line TSH and the horizontal height line HZH with respect to the both ends of and the body 140 in case that the electrostatic chuck 141 is tensioned by the tensioned length TSL.

**[Table 3]**

| | | | | |
|---|---|---|---|---|
| Tension Length (mm) | 0 | 0.1 | 0.2 | 0.5 |
| Amount of Deflection (mm) | 2.4 | 0.93 | 0.31 | -0.96 |

It can be seen from the data of Table 2 and Table 3 that the electrostatic chuck 140 according to this embodiment exhibits even more improved amount of deflection DEF according to the tension length TSL compared to the electrostatic chuck 140 described above with reference to FIG. 6 and the like within the scope of the disclosure. It can be seen that as the tension length TSL increases, the difference between the amount of deflection DEF of the electrostatic chuck 140 according to this embodiment and the amount of deflection DEF of the electrostatic chuck 140 according to the above-described embodiment increases. In other words, it can be seen that the degree of improvement in the amounts of deflection DEF increases as the tensile length TSL increases.

Like the electrostatic chuck 140 according to this embodiment, by introducing the grooves GRV and the tension assist device 142 together, the effect of preventing deflection can be further increased.

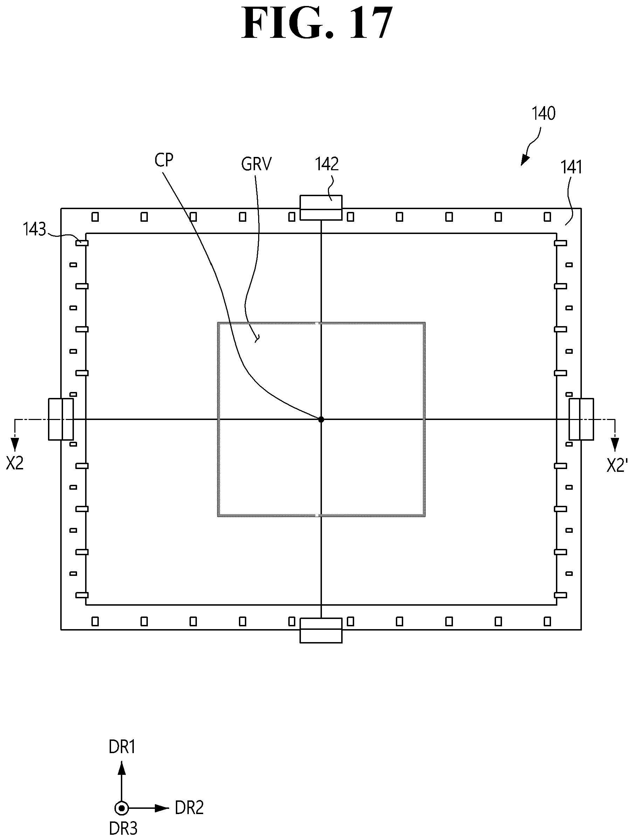

FIG. 17 is a schematic plan view showing an electrostatic chuck according to an embodiment.

An electrostatic chuck 140 according to an embodiment of FIG. 17 may be different from the electrostatic chuck 140 according to an embodiment described above with reference to FIG. 13 and the like in that a single groove GRV may be formed.

For example, the groove GRV of the electrostatic chuck 140 according to this embodiment may be formed as a single groove.

As shown in the drawings, the single groove GRV may have a rectangular or square shape extended in the first and second directions DR1 and DR2 when viewed from the top. It should be understood, however, that the shape of the groove GRV is not limited thereto. The shape of the groove GRV may have various shapes such as a circular shape, a diamond shape, and a polygonal shape when viewed from the top.

Hereinafter, a method for fabricating a display panel using the deposition apparatus according to the above-described embodiments will be described.

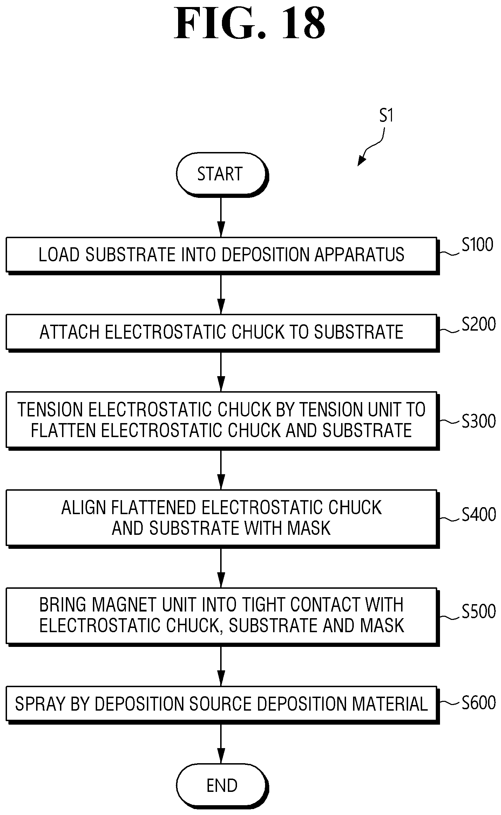

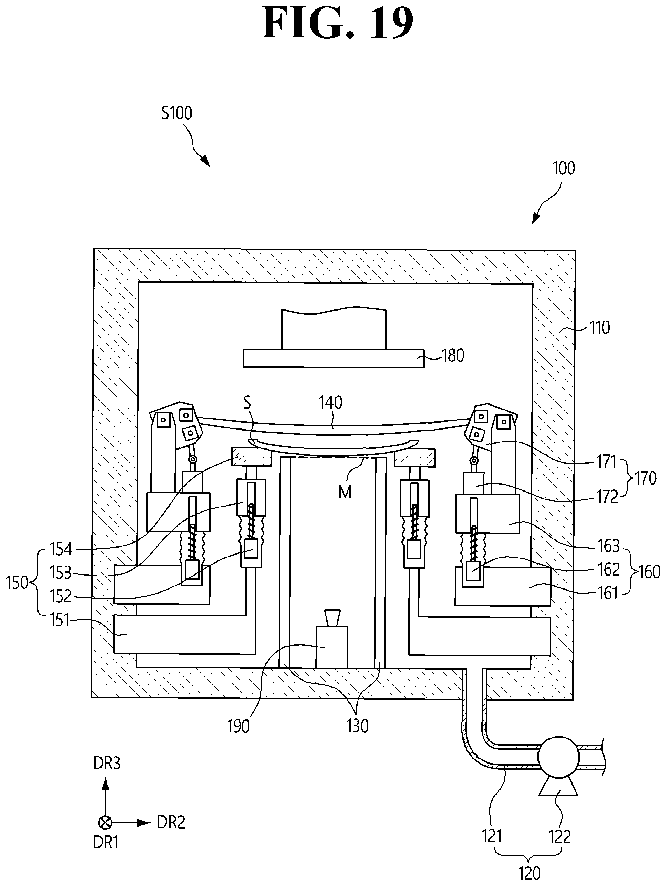

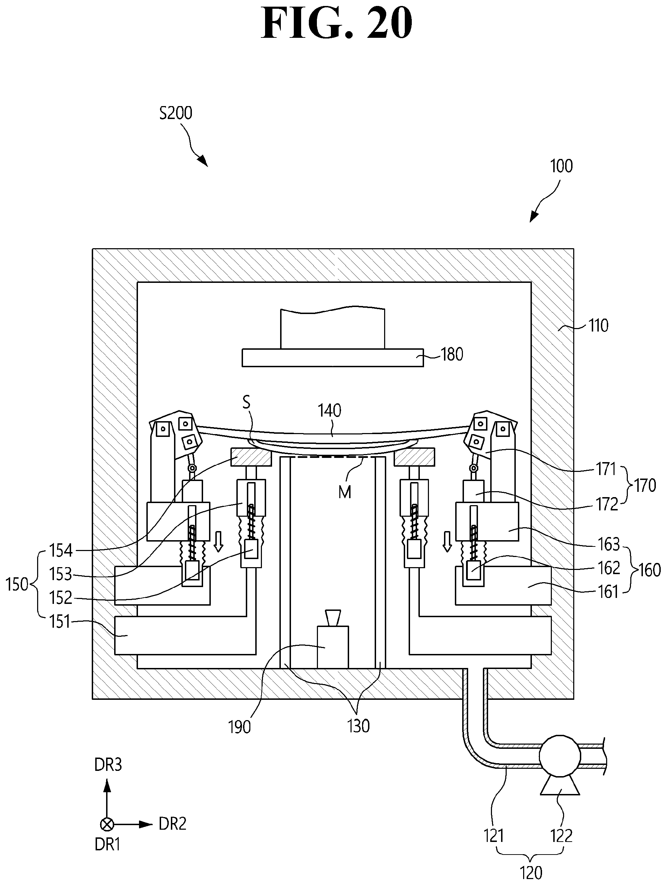

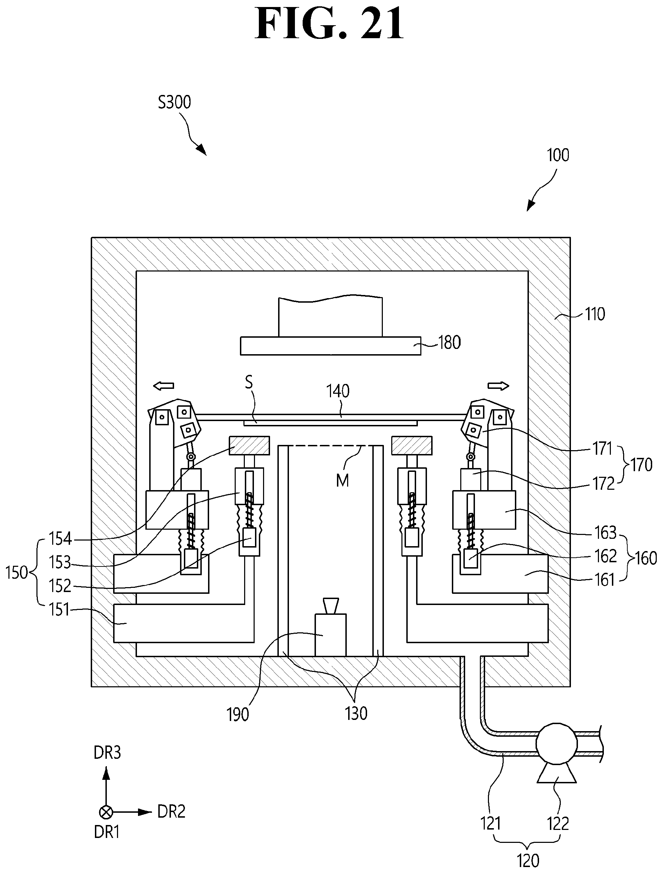

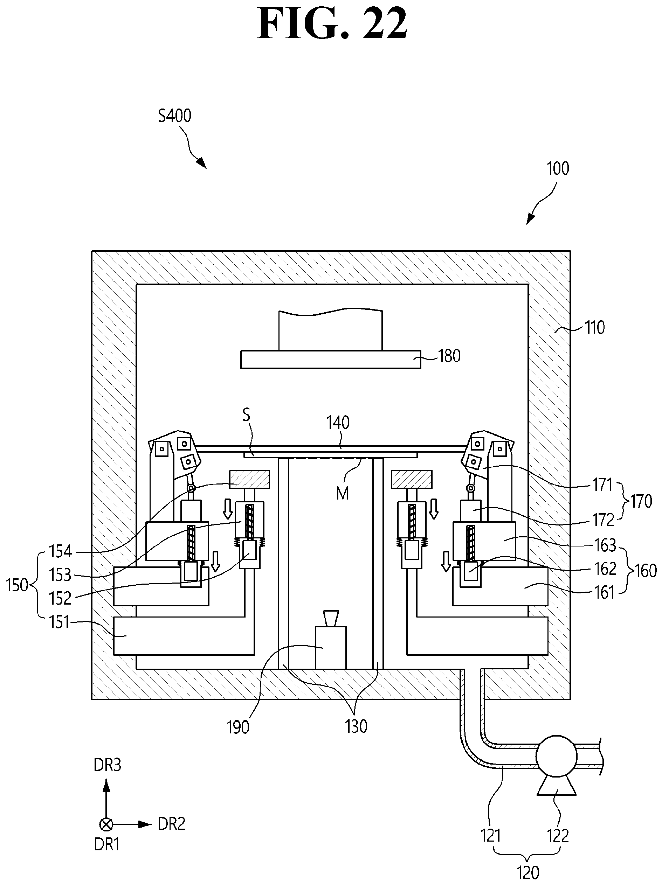

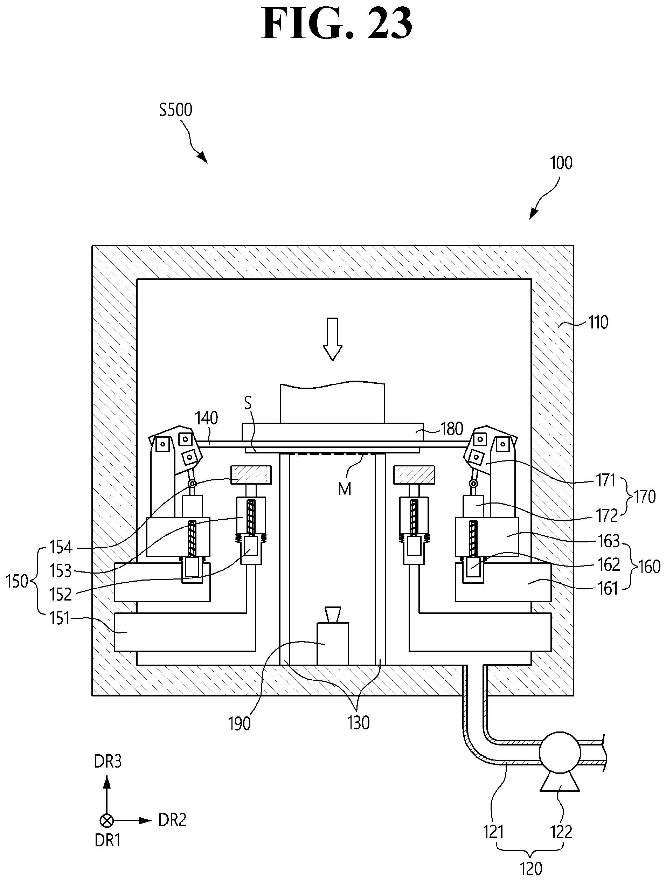

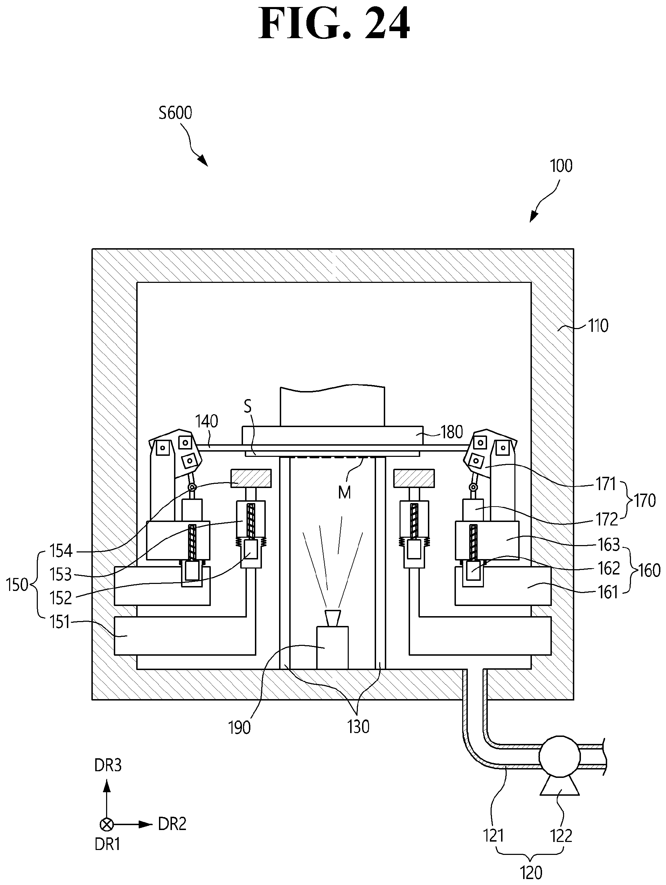

FIG. 18 is a flowchart for illustrating a method of fabricating a display panel according to an embodiment. FIG. 19 is a schematic cross-sectional view showing step S100 of FIG. 18. FIG. 20 is a schematic cross-sectional view showing step S200 of FIG. 18. FIG. 21 is a schematic cross-sectional view showing step S300 of FIG. 18. FIG. 22 is a schematic cross-sectional view showing step S400 of FIG. 18. FIG. 23 is a schematic cross-sectional view showing step S500 of FIG. 18. FIG. 24 is a schematic cross-sectional view showing step S600 of FIG. 18.

Referring to FIGS. 18 to 24, a method S1 for fabricating a display panel according to an embodiment may include loading a substrate into a deposition apparatus (step S100); attaching an electrostatic chuck to the substrate (step S200); flattening, by the tension unit, the electrostatic chuck and the substrate by tensioning the electrostatic chuck (step S300); aligning the flattened electrostatic chuck and the substrate with the mask (step S400); brining, by a magnet unit, the electrostatic chuck, the substrate and the mask into tight contact (step S500); and spraying, by a deposition source, a deposition material (step S600).

The loading S100 the substrate into the deposition apparatus may include providing, by a robot arm (not shown), the substrate S from the outside of the chamber 110 to the inside of the chamber 110. The substrate S provided into the chamber 110 may be disposed between the mask M and the electrostatic chuck 140 in the third direction DR3.

The attaching S200 the electrostatic chuck to the substrate may include moving, by a second lifting unit 160, the electrostatic chuck 140 toward the substrate S. For example, the second connector 163, the tension unit 170 and the electrostatic chuck 140 may descend toward the substrate S by driving the second driver 162 of the second lifting unit 160.

While, before or after the electrostatic chuck 140 descends toward the substrate S, the electrostatic chuck 140 may be aligned with the substrate S by an aligning device (not shown) recognizing the alignment marks 143 (see FIG. 2 ) of the electrostatic chuck 140.

After the electrostatic chuck 140 has descended, it may generate electrostatic force to attach the substrate S thereto.

The flattening S300, by the tension unit, the electrostatic chuck and the substrate by tensioning the electrostatic chuck may include tensioning, by the tension unit 170, the electrostatic chuck 140. For example, by driving the third driver 172 of the tension unit 170, the presser 171 may generate a tensile force in the first direction DR1 or the second direction DR2.

The presser 171 may be coupled to the stepped portion 142c (see FIG. 4) or the auxiliary end 142d (see FIG. 11) of the above-described tension assist device 142, to apply a tensile force to the tension assist device 142 having a high difference, thereby flattening the body 141 of the electrostatic chuck 140. The substrate S attached by the electrostatic force of the electrostatic chuck 140 may be flattened together with the electrostatic chuck 140.

The aligning S400 the flattened electrostatic chuck and the substrate with the mask may include operating the second lifting unit 160 to move the electrostatic chuck 140 to the attached substrate S toward the substrate S. For example, the second connector 163, the tension unit 170, the electrostatic chuck 140 and the attached substrate S may descend toward the mask M by driving the second driver 162 of the second lifting unit 160.

In case that the support plate 154 of the first lifting unit 150 is positioned higher than the mask M on the mask holder 130, as the electrostatic chuck 140 and the substrate S descend toward the mask M, the electrostatic chuck 140 and the substrate S may collide with the support plate 154. Accordingly, the first lifting unit 150 may operate to move the support plate 154 to a lower position than the mask M on the mask holder 130. For example, the first connector 153 and the support plate 154 may be lowered by the driving of the first driver 152 of the first lifting unit 150, and the support plate 154 may be moved to a position lower than the mask M on the mask holder 130.

While, before or after the electrostatic chuck 140 and the attached substrate S are lowered, the electrostatic chuck 140 and the substrate S may be aligned with the mask M by an aligning device (not shown). For alignment with the mask M, the substrate S and the mask M may each include alignment marks.

After the electrostatic chuck 140 and the attached substrate S have been descended, the substrate S may be in contact with the mask M.

The brining S500, by the magnet unit, the electrostatic chuck, the substrate and the mask into tight contact may include moving the magnitude unit 180 toward the electrostatic chuck 140, the substrate S and the mask M. In this instance, the deposition apparatus 100 may further include a separate lifting device (not shown) capable of lifting the magnet unit 180.

After the magnet unit 180 has descended, it may be in contact with the electrostatic chuck 140. The magnet unit in contact with the electrostatic chuck 140 may apply magnetic force to bring the mask M disposed on the opposite side to the substrate S with the electrostatic chuck 140 therebetween. Furthermore, the magnet unit 180 may apply pressure to the electrostatic chuck 140, the substrate S and the mask M, which are attached to each other, to further bring them into tight contact.

The spraying S600 the deposition material by the deposition source may include spraying, by the deposition source 190, a deposition material. The deposition material sprayed from the deposition source 190 may pass through the mask M and settle on the substrate S.

Hereinafter, a display panel fabricated using the deposition apparatus and the method for fabricating a display panel according to the above-described embodiments will be described.

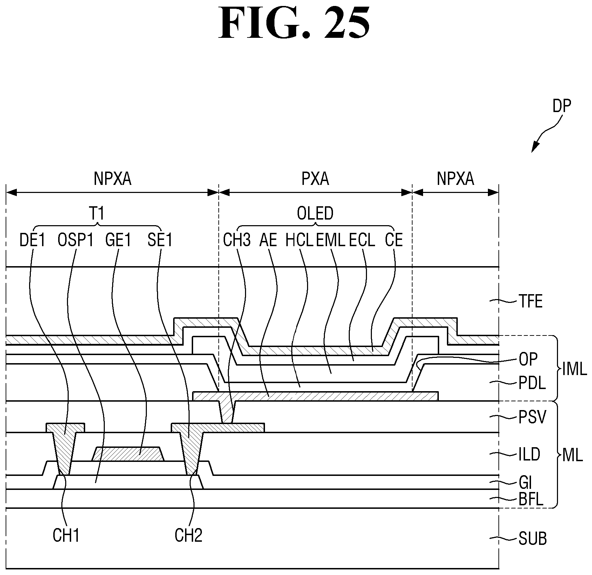

FIG. 25 is a schematic cross-sectional view illustrating an example of a display panel fabricated using the deposition apparatus and the method for fabricating a display panel according to the above-described embodiments.

Referring to FIG. 25, a display panel DP may include a substrate SUB, a circuit element layer ML, a display element layer IML, and a thin-film encapsulation layer TFE. The circuit element layer ML, the display element layer IML and the thin-film encapsulation layer TFE may be sequentially disposed on the substrate SUB.

The substrate SUB may include a synthetic resin film. A synthetic resin layer may be formed on a process substrate used in fabricating the display panel DP. Sequentially, a conductive layer, an insulating layer, etc. may be formed on the synthetic resin layer. In case that the process substrate is removed, the synthetic resin layer may correspond to the substrate SUB. The synthetic resin layer may include a thermosetting resin. By way of example, the synthetic resin layer may be a polyimide-based resin layer, and the material thereof is not particularly limited. Besides, the substrate SUB may include an organic/inorganic composite material substrate, etc.

According to this embodiment, the circuit element layer ML may include an inorganic buffer film BFL, a first intermediate inorganic film GI, and a second intermediate inorganic film ILD, and an organic intermediate organic layer PSV. The materials of the inorganic film and the organic film are not particularly limited herein. According to an embodiment, the buffer film BFL is an optional element and thus may be eliminated.

A semiconductor pattern OSP1 of a transistor T1 may be disposed on the buffer film BFL. The semiconductor pattern OSP1 may be selected from among amorphous silicon, polysilicon, and metal oxide semiconductor.

The first intermediate inorganic film GI may be disposed on the semiconductor pattern OSP1. A control electrode GE1 of the transistor T1 may be disposed on the first intermediate inorganic film GI.

A second intermediate inorganic film ILD covering the control electrode GE1 may be disposed on the first intermediate inorganic film GI. An input electrode DE1 and an output electrode SE1 of the transistor T1 may be disposed on the second intermediate inorganic film ILD.

The input electrode DE1 and the output electrode SE1 may be connected to the semiconductor pattern OSP1 through a first through hole CH1 and a second through hole CH2 penetrating the first intermediate inorganic film GI and the second intermediate inorganic film ILD. According to an embodiment, the transistor T1 may be modified to have a bottom-gate structure.

The intermediate organic film PSV covering the input electrode DE1 and the output electrode SE1 may be disposed on the second intermediate inorganic film ILD. The intermediate organic film PSV may provide a flat surface.

The display element layer IML may be disposed on the intermediate organic film PSV. The display element layer IML may include a pixel-defining film PDL and an organic light-emitting diode (OLED). The pixel-defining film PDL may include an organic material. A first electrode AE may be disposed on the intermediate organic film PSV. The first electrode AE may be connected to the output electrode SE1 through a third through hole CH3 penetrating the intermediate organic film PSV. An opening OP may be defined in the pixel-defining film PDL. The opening OP may expose at least a part of the first electrode AE. According to an embodiment, the pixel-defining film PDL may be eliminated.

According to an embodiment, an emission area PXA may overlap the transistor T1.

A hole control layer HCL may be disposed in common in the emission area PXA and a non-emission area NPXA. An emissive layer EML may be disposed on the hole control layer HCL. The emissive layer EML may be disposed in an area corresponding to the opening OP. The emissive layer EML may include an organic material and/or an inorganic material. The emissive layer EML may generate a light of a given color.

An electron control layer ECL may be disposed on the emissive layer EML. A second electrode CE may be disposed on the electron control layer ECL.

The thin-film encapsulation layer TFE may be disposed on the second electrode CE. The thin-film encapsulation layer TFE may cover the second electrode CE. A capping layer (not shown) may be further disposed between the thin-film encapsulation layer TFE and the second electrode CE to cover the second electrode CE. In this instance, the thin-film encapsulation layer TFE may directly cover the capping layer (not shown).

As discussed, embodiments mat provide a electrostatic chuck comprising: a body; and
a tension assist device disposed at a border of the body, wherein the tension assist device comprises a stepped portion disposed on a side of the body, and an end of the stepped portion is disposed higher than an upper surface of the body.

Here, the upper surface of the body may be a surface facing away from the gravity direction.

In use electrostatic chuck may be placed above a substrate. The size of the electrostatic chuck may be larger than that of the substrate. Accordingly, like the substrate, the electrostatic chuck may tend to deflect toward the substrate, for example, in the downward direction due to its own weight.

The electrostatic chuck may attach the substrate with electrostatic force by applying a voltage to an electrode pattern.

The electrostatic chuck may have a thin plate shape. The electrostatic chuck may be made of a thin film.

According to an embodiment, the thickness of the electrostatic chuck may be, but is not limited to, about 10 mm.

In use, the body may have the same general the shape as that of the substrate. For example, the body may have a rectangular shape.

The body may include two shorter sides extended in the first direction and facing each other in the second direction, and two longer sides extended in the second direction and facing each other in the first direction. The size of the body may be larger than that of the substrate.

The tension assist devices may be coupled to the body. The tension assist devices may be coupled to the border of the body, for example, the edges of the body. According to an embodiment, the tension assist devices may be disposed at the centers of the sides of the body, respectively.

The body may include a first base, an electrode pattern, an insulating film, and a second base.

Electrostatic force may be generated by the alternately arranged first electrode patterns and second electrode patterns, and in use the substrate may be attached to the electrostatic chuck by the electrostatic force.

A tension assist device may include a coupling portion, a recessed portion, and a stepped portion.

The coupling portion may fix the tension assist device to the body. The coupling portion may overlap the edge of the body in the third direction in case that the tension assist device is coupled to the body.

The coupling portion may be in direct contact with the first base and the second base of the body. For example, the coupling portion may include an upper end and a lower end. The body may be disposed between the upper end and the lower end of the coupling portion in the third direction. The upper and lower ends of the coupling part may be engaged with the body to fix the tension assist device to the body.

The coupling portion may have a shape protruding from the stepped portion to one side or a side in the first direction or the second direction. For example, the coupling portion may protrude toward the body in the first direction or the second direction with the recessed portion therebetween in the third direction. The coupling portion may overlap the recessed portion in the third direction.

The body may be inserted into the recessed portion. The recessed portion may provide a space into which the body can be inserted. The recessed portion may overlap the edge of the body in the third direction in case that the tension assist device is coupled to the body. The recessed portion may accommodate the body so that the body can be inserted into the tension assist device.

The stepped portion may be disposed on one side or a side of the body. The stepped portion may have a shape protruding to one side or a side from the coupling portion and the recessed portion. For example, the stepped portion may have a shape protruding in a diagonal direction between the opposite direction to the first direction and the third direction, or in a diagonal direction between the opposite direction to the second direction and the third direction.

One end or an end of the stepped portion, for example, the end distant from the body, may be disposed higher than the upper surface of the body. For example, the end of the stepped portion may be positioned higher than the upper surface of the body by a first height. The first height may range from about several millimeters to about several tens of millimeters. The end of the stepped portion may be disposed higher than the upper surface of the coupling portion.

Embodiments may provide a deposition apparatus including an electrostatic chuck according to any of the described embodiments.

In concluding the detailed description, those skilled in the art will appreciate that many variations and modifications can be made to the disclosed embodiments without substantially departing from the principles of the disclosure. Therefore, the disclosed embodiments are used in a generic and descriptive sense only and not for purposes of limitation.

## Claims

1. An electrostatic chuck (140) for use in a deposition apparatus, the electrostatic chuck comprising:
a body (141) having an upper surface, a lower surface, and a plurality of sides; and
a tension assist device (142) disposed at a border of the body (141); wherein:
the tension assist device comprises a stepped portion (142c) disposed on a side of the plurality of sides of the body, and
an end of the stepped portion, distant from the body, is disposed higher than the upper surface of the body, and
wherein the tension assist device is configured to receive a tensile force from a tension part (170) of the deposition apparatus to flatten the body of the electrostatic chuck,
wherein the tension assist device (142) further comprises:
a recessed portion (142b) to which the body (141) is inserted; and
a coupling portion (142a) overlapping the recessed portion (142b) and fixing the tension assist device (142) to the body (141), and
the stepped portion (142c) is disposed on a side of the recessed portion and the coupling portion.

2. The electrostatic chuck of claim 1, wherein an angle formed between an extension direction of the stepped portion and an extension direction of the coupling portion is less than about 180 degrees.

3. The electrostatic chuck of claim 1 or 2, wherein the tension assist device further comprises an auxiliary end (142d) disposed on a side of the stepped portion and disposed on an opposite side of the coupling portion with the stepped portion disposed between the auxiliary end (142d) and the coupling portion (142a).

4. The electrostatic chuck of claim 3, wherein an extension direction of the auxiliary end is parallel to an extension direction of the coupling portion.

5. The electrostatic chuck of claim 3 or 4, wherein an extension direction of a side surface of an end of the auxiliary end is parallel to an extension direction of a side surface of an end of the body.

6. The electrostatic chuck of any one of claims 1 to 5, wherein:
the body comprises:
a first base (BS1) and a second base (BS2) facing each other;
an electrode pattern (ETP) disposed between the first base and the second base; and
an insulating film (ISL) disposed between the first base and the second base and surrounding the electrode pattern, and
the first base and the second base directly contact the coupling portion.

7. The electrostatic chuck of any one of claims 1 to 6, wherein:
the body comprises the plurality of sides surrounding the border, and
the tension assist device is disposed at a point closest to a center of gravity of the body on each of the plurality of sides;
optionally wherein the plurality of the sides comprises: a first side and a second side extended in a first direction and facing each other; and a third side and a fourth side extended in a second direction different from the first direction and facing each other, and the tension assist device is disposed at a center of each of the first side, the second side, the third side, and the fourth side.

8. The electrostatic chuck of any one of claims 1 to 7, wherein the body includes at least one groove (GRV) recessed in a thickness direction of the body;
optionally wherein the at least one groove comprises a plurality of grooves extended in a first direction and disposed in a second direction different from the first direction or wherein the at least one groove comprises a single groove extended in a first direction and a second direction different from the first direction.

9. The electrostatic chuck of claim 8, wherein the groove is disposed adjacent to a center of gravity of the body.

10. A deposition apparatus (100) comprising:
a chamber (110);
an electrostatic chuck (140) disposed in the chamber, wherein the electrostatic chuck has a body; and
a tension part (170) arranged to apply a tensile force to tension the electrostatic chuck to flatten the body of the electrostatic chuck, wherein
the electrostatic chuck (140) is according to any one of claims 1 to 9.

11. The deposition apparatus of claim 10 when dependent on claim 3, wherein the tension part (170) is arranged to apply the tensile force in an extending direction of the auxiliary end.

12. The deposition apparatus of claim 10 or 11 when dependent on claim 3, wherein the tension part comprises:
a presser (171) connected to the auxiliary end arranged to provide a tensile force to the electrostatic chuck; and
a driver connected to the presser and arranged to provide a driving force to the presser.

13. The deposition apparatus of any one of claims 10 to 12, further comprising:
a second lifting part (160) disposed below the tension part and arranged to elevate the tension part;
a first lifting part (150) disposed on a side of the second lifting part and arranged to seat a substrate;
a mask holder (130) disposed on a side of the first lifting part and arranged to seat a mask;
a magnet part disposed above the electrostatic chuck and arranged to press the substrate against the mask; and
a deposition source (190) disposed below the electrostatic chuck and arranged to spray a deposition material.

## Patentansprüche

1. Elektrostatische Einspannvorrichtung (140) zur Verwendung in einer Abscheidungsvorrichtung, wobei die elektrostatische Einspannvorrichtung Folgendes umfasst:
einen Körper (141) mit einer oberen Oberfläche, einer unteren Oberfläche und einer Vielzahl von Seiten; und
ein Zugunterstützungsgerät (142), das an einem Rand des Körpers (141) angeordnet ist;
wobei:
das Zugunterstützungsgerät einen gestuften Abschnitt (142c) umfasst, der an einer Seite der Vielzahl von Seiten des Körpers angeordnet ist, und
wobei ein vom Körper entferntes Ende des gestuften Abschnitts höher als die obere Oberfläche des Körpers angeordnet ist und
wobei das Zugunterstützungsgerät dazu konfiguriert ist, eine Zugkraft von einem Zugteil (170) der Abscheidungsvorrichtung zu empfangen, um den Körper der elektrostatischen Einspannvorrichtung abzuflachen,
wobei das Zugunterstützungsgerät (142) ferner Folgendes umfasst:
einen ausgesparten Abschnitt (142b), in den der Körper (141) eingeführt wird; und
ein Kopplungsabschnitt (142a), der den ausgesparten Abschnitt (142b) überlappt und das Zugunterstützungsgerät (142) an dem Körper (141) befestigt, und
wobei der gestufte Abschnitt (142c) an einer Seite des ausgesparten Abschnitts und des Kopplungsabschnitts angeordnet ist.

2. Elektrostatische Einspannvorrichtung nach Anspruch 1, wobei ein Winkel, der zwischen einer Erstreckungsrichtung des gestuften Abschnitts und einer Erstreckungsrichtung des Kopplungsabschnitts gebildet wird, weniger als etwa 180 Grad beträgt.

3. Elektrostatische Einspannvorrichtung nach Anspruch 1 oder 2, wobei das Zugunterstützungsgerät ferner ein Hilfsende (142d) umfasst, das an einer Seite des gestuften Abschnitts angeordnet ist und an einer gegenüberliegenden Seite des Kopplungsabschnitts angeordnet ist, wobei der gestufte Abschnitt zwischen dem Hilfsende (142d) und dem Kopplungsabschnitt (142a) angeordnet ist.

4. Elektrostatische Einspannvorrichtung nach Anspruch 3, wobei eine Erstreckungsrichtung des Hilfsendes parallel zu einer Erstreckungsrichtung des Kopplungsabschnitts ist.

5. Elektrostatische Einspannvorrichtung nach Anspruch 3 oder 4, wobei eine Erstreckungsrichtung einer Seitenoberfläche eines Endes des Hilfsendes parallel zu einer Erstreckungsrichtung einer Seitenoberfläche eines Endes des Körpers ist.

6. Elektrostatische Einspannvorrichtung nach einem der Ansprüche 1 bis 5, wobei:
der Körper Folgendes umfasst:
eine erste Basis (BS1) und eine zweite Basis (BS2), die einander zugewandt sind;
ein Elektrodenmuster (ETP), das zwischen der ersten Basis und der zweiten Basis angeordnet ist; und
eine Isolierfolie (ISL), die zwischen der ersten Basis und der zweiten Basis angeordnet ist und das Elektrodenmuster umgibt, und
wobei die erste Basis und die zweite Basis den Kopplungsabschnitt direkt berühren.

7. Elektrostatische Einspannvorrichtung nach einem der Ansprüche 1 bis 6, wobei:
der Körper die Vielzahl von Seiten umfasst, die den Rand umgeben, und
das Zugunterstützungsgerät an einem Punkt angeordnet ist, der einem Schwerpunkt des Körpers an jeder der Vielzahl von Seiten am nächsten liegt;
optional wobei die Vielzahl der Seiten Folgendes umfasst: eine erste Seite und eine zweite Seite, die sich in eine erste Richtung erstrecken und einander zugewandt sind; und eine dritte Seite und eine vierte Seite, die sich in eine zweite Richtung erstrecken, die sich von der ersten Richtung unterscheidet, und einander zugewandt sind, und das Zugunterstützungsgerät in einer Mitte von jeder der ersten Seite, der zweiten Seite, der dritten Seite und der vierten Seite angeordnet ist.

8. Elektrostatische Einspannvorrichtung nach einem der Ansprüche 1 bis 7, wobei der Körper mindestens eine Nut (GRV) beinhaltet, die in einer Dickenrichtung des Körpers ausgespart ist;
optional, wobei die mindestens eine Nut eine Vielzahl von Nuten umfasst, die sich in eine erste Richtung erstrecken und in einer zweiten Richtung angeordnet sind, die sich von der ersten Richtung unterscheidet, oder wobei die mindestens eine Nut eine einzelne Nut umfasst, die sich in eine erste Richtung und eine zweite Richtung erstreckt, die sich von der ersten Richtung unterscheidet.

9. Elektrostatische Einspannvorrichtung nach Anspruch 8, wobei die Nut benachbart zu einem Schwerpunkt des Körpers angeordnet ist.

10. Abscheidungsvorrichtung (100), umfassend:
eine Kammer (110);
eine elektrostatische Einspannvorrichtung (140), die in der Kammer angeordnet ist, wobei die elektrostatische Einspannvorrichtung einen Körper aufweist; und
ein Zugteil (170), das dazu eingerichtet ist, eine Zugkraft aufzubringen, um die elektrostatische Einspannvorrichtung zu spannen, um den Körper der elektrostatischen Einspannvorrichtung abzuflachen, wobei
die elektrostatische Einspannvorrichtung (140) gemäß einem der Ansprüche 1 bis 9 ist.

11. Abscheidungsvorrichtung nach Anspruch 10, wenn abhängig von Anspruch 3, wobei das Zugteil (170) dazu eingerichtet ist, die Zugkraft in einer Erstreckungsrichtung des Hilfsendes aufzubringen.

12. Abscheidungsvorrichtung nach Anspruch 10 oder 11, wenn abhängig von Anspruch 3, wobei das Zugteil Folgendes umfasst:
einen Drücker (171), der mit dem Hilfsende verbunden ist, das dazu eingerichtet ist, der elektrostatischen Einspannvorrichtung eine Zugkraft bereitzustellen; und
einen Mitnehmer, der mit dem Drücker verbunden ist und dazu eingerichtet ist, dem Drücker eine Antriebskraft bereitzustellen.

13. Abscheidungsvorrichtung nach einem der Ansprüche 10 bis 12, ferner umfassend:
ein zweites Hebeteil (160), das unter dem Zugteil angeordnet ist und dazu eingerichtet ist, das Zugteil anzuheben;
ein erstes Hebeteil (150), das auf einer Seite des zweiten Hebeteils angeordnet ist und dazu eingerichtet ist, ein Substrat aufzunehmen;
einen Maskenhalter (130), der auf einer Seite des ersten Hebeteils angeordnet ist und dazu eingerichtet ist, eine Maske aufzunehmen;
ein Magnetteil, der über der elektrostatischen Einspannvorrichtung angeordnet ist und dazu eingerichtet ist, das Substrat gegen die Maske zu drücken; und
eine Abscheidungsquelle (190), die unter der elektrostatischen Einspannvorrichtung angeordnet ist und dazu eingerichtet ist, ein Abscheidungsmaterial zu sprühen.

## Revendications

1. Mandrin électrostatique (140) destiné à être utilisé dans un appareil de dépôt, le mandrin électrostatique comprenant :
un corps (141) comportant une surface supérieure, une surface inférieure et une pluralité de côtés ; et
un dispositif d'assistance à la tension (142) disposé au niveau d'un bord du corps (141) ;
ledit dispositif d'assistance à la tension comprenant une partie étagée (142c) disposée sur un côté de la pluralité de côtés du corps, et
une extrémité de la partie étagée, éloignée du corps, étant disposée plus haute que la surface supérieure du corps, et
ledit dispositif d'assistance à la tension étant conçu pour recevoir une force de traction provenant d'une partie de tension (170) de l'appareil de dépôt pour aplatir le corps du mandrin électrostatique, ledit dispositif d'assistance à la tension (142) comprenant en outre :
une partie évidée (142b) dans laquelle le corps (141) est inséré ; et
une partie d'accouplement (142a) chevauchant la partie évidée (142b) et fixant le dispositif d'assistance à la tension (142) au corps (141), et
ladite partie étagée (142c) étant disposée sur un côté de la partie évidée et de la partie d'accouplement.

2. Mandrin électrostatique de la revendication 1, un angle formé entre une direction d'extension de la partie étagée et une direction d'extension de la partie d'accouplement étant inférieur à environ 180 degrés.

3. Mandrin électrostatique de la revendication 1 ou 2, ledit dispositif d'assistance à la tension comprenant en outre une extrémité auxiliaire (142d) disposée sur un côté de la partie étagée et disposée sur un côté opposé de la partie d'accouplement, la partie étagée étant disposée entre l'extrémité auxiliaire (142d) et la partie d'accouplement (142a).

4. Mandrin électrostatique de la revendication 3, une direction d'extension de l'extrémité auxiliaire étant parallèle à une direction d'extension de la partie d'accouplement.

5. Mandrin électrostatique de la revendication 3 ou 4, une direction d'extension d'une surface latérale d'une extrémité de l'extrémité auxiliaire étant parallèle à une direction d'extension d'une surface latérale d'une extrémité du corps.

6. Mandrin électrostatique de l'une quelconque des revendications 1 à 5,
ledit corps comprenant :
une première base (BS1) et une seconde base (BS2) se faisant face l'une à l'autre ;
un motif d'électrode (ETP) disposé entre la première base et la seconde base ; et
un film isolant (ISL) disposé entre la première base et la seconde base et entourant le motif d'électrode, et
ladite première base et ladite seconde base étant directement en contact avec la partie d'accouplement.

7. Mandrin électrostatique de l'une quelconque des revendications 1 à 6,
ledit corps comprenant la pluralité de côtés entourant le bord, et
ledit dispositif d'assistance à la tension étant disposé au niveau du point le plus proche d'un centre de gravité du corps sur chacun de la pluralité de côtés ;
éventuellement, ladite pluralité de côtés comprenant : un premier côté et un deuxième côté s'étendant dans une première direction et se faisant face ; et un troisième côté et un quatrième côté s'étendant dans une seconde direction différente de la première direction et se faisant face, et ledit dispositif d'assistance à la tension étant disposé au centre de chacun du premier côté, du deuxième côté, du troisième côté et du quatrième côté.

8. Mandrin électrostatique de l'une quelconque des revendications 1 à 7, ledit corps comprenant au moins une rainure (GRV) en retrait dans la direction de l'épaisseur du corps ;
éventuellement, ladite au moins une rainure comprenant une pluralité de rainures s'étendant dans une première direction et disposées dans une seconde direction différente de la première direction ou ladite au moins une rainure comprenant une rainure unique s'étendant dans une première direction et une seconde direction différente de la première direction.

9. Mandrin électrostatique de la revendication 8, ladite rainure étant disposée adjacente à un centre de gravité du corps.

10. Appareil de dépôt (100) comprenant :
une chambre (110) ;
un mandrin électrostatique (140) disposé dans la chambre, ledit mandrin électrostatique possédant un corps ; et
une partie de tension (170) agencée pour appliquer une force de traction afin de tendre le mandrin électrostatique pour aplatir le corps du mandrin électrostatique,
ledit mandrin électrostatique (140) étant selon l'une quelconque des revendications 1 à 9.

11. Appareil de dépôt de la revendication 10 lorsqu'elle dépend de la revendication 3, ladite partie de tension (170) étant agencée pour appliquer la force de traction dans une direction d'extension de l'extrémité auxiliaire.

12. Appareil de dépôt de la revendication 10 ou 11 lorsqu'elle dépend de la revendication 3, ladite partie de tension comprenant :
un presseur (171) relié à l'extrémité auxiliaire agencé pour fournir une force de traction au mandrin électrostatique ; et
un dispositif d'entraînement relié au presseur et agencé pour fournir une force d'entraînement au presseur.

13. Appareil de dépôt de l'une quelconque des revendications 10 à 12, comprenant en outre :
une seconde partie de levage (160) disposée sous la partie de tension et agencée pour élever la partie de tension ;
une première partie de levage (150) disposée sur un côté de la seconde partie de levage et agencée pour asseoir un substrat ;
un support de masque (130) disposé sur un côté de la première partie de levage et agencé pour asseoir un masque ;
une partie magnétique disposée au-dessus du mandrin électrostatique et agencée pour presser le substrat contre le masque ; et
une source de dépôt (190) disposée au-dessous du mandrin électrostatique et agencée pour pulvériser un matériau de dépôt.
